(19) Europäisches Patentamt
European Patent Office
Office européen des brevets

(11) Veröffentlichungsnummer: **0 303 879 B1**

(12) **EUROPÄISCHE PATENTSCHRIFT**

(45) Veröffentlichungstag der Patentschrift:
17.04.91 Patentblatt 91/16

(51) Int. Cl.⁵: **G01R 33/34**

(21) Anmeldenummer: **88112470.5**

(22) Anmeldetag: **01.08.88**

(54) **Lokalspule für die Untersuchung eines Objektes mit Hilfe der kernmagnetischen Resonanz.**

(30) Priorität: **13.08.87 DE 3727056**

(43) Veröffentlichungstag der Anmeldung:
**22.02.89 Patentblatt 89/08**

(45) Bekanntmachung des Hinweises auf die
Patenterteilung:
**17.04.91 Patentblatt 91/16**

(84) Benannte Vertragsstaaten:
**DE FR GB**

(56) Entgegenhaltungen:
**EP-A- 0 200 078
EP-A- 0 222 982
WO-A-82/00378**

(56) Entgegenhaltungen:
**WO-A-84/00214
GB-A- 2 159 958
ANTENNA ENGINEERING HANDBOOK, LOOP
ANTENNAS, CHAPTER 5, SEITE 5-13; GLENN
S. SMITH, GEORGIA INSTITUTE OF TECHNO-
LOGY.**

(73) Patentinhaber: **Siemens Aktiengesellschaft
Wittelsbacherplatz 2
W-8000 München 2 (DE)**

(72) Erfinder: **Zabel, Hans-Joachim
Freiburgerstr. 43
W-6900 Heidelberg (DE)**
Erfinder: **Lorenz, Walter J., Prof. Dr.
Kastellweg 26
W-6900 Heidelberg (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Lokalspule für die spektroskopische oder bildgebende Untersuchung eines Objektes mit Hilfe der kernmagnetischen Resonanz, wobei die Lokalspule ein zu einer ersten Windung geformtes Koaxialleiterstück aufweist und wobei an einem Ende des Koaxialleiterstückes der Innenleiter mit der Mantelabschirmung am Anfang der ersten Windung elektrisch verbunden ist.

Eine derartige Lokalspule ist beispielsweise aus der EP-A1-0 222 982 bekannt.

Lokalspulen werden in der Kernspin-Tomographie und in der Kernspin-Spektroskopie verwendet, wenn bestimmte Teile des Untersuchungsobjektes mit verbessertem Signal-Rausch-Verhältnis ausgewertet werden sollen. Dabei wird das Untersuchungsobjekt in ein homogenes magnetisches Grundfeld einer MR-Anlage gebracht. Die Lokalspule wird in der Nähe des zu untersuchenden Bereiches positioniert. In dem zu untersuchenden Bereich werden mit Hilfe von Hochfrequenzimpulsen die Kernspins des Untersuchungsobjektes angeregt. Diese Anregung kann entweder durch die Lokalspule oder eine den gesamten Untersuchungsbereich erfassende Antenne erfolgen. Danach wird das von den angeregten Kernspins ausgesandte Kernresonanzsignal von der Lokalspule aufgenommen und in einer MR-Anlage abgespeichert. Für die ortsaufgelöste Spektroskopie und für Bildgebung werden dem homogenen magnetischen Grundfeld zusätzlich noch magnetische Gradientenfelder aufgeschaltet.

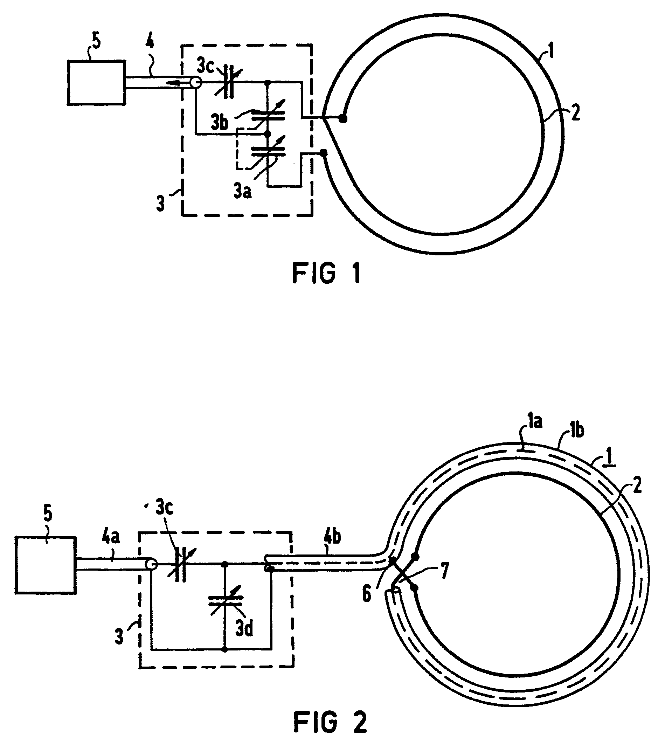

Eine herkömmliche Lokalspule ist zur Erläuterung der Problemstellung in FIG 1 dargestellt. Die Lokalspule besteht aus zwei koaxialen Windungen 1 und 2. Mit der zweiten Windung wird gegenüber einer einzigen Windung eine Erhöhung der Gesamt-Induktivität der Lokalspule und damit eine Erhöhung des Signal-Rausch-Verhältnisses erreicht. Die Lokalspule wird über eine Koaxialleitung 4 an einen Empfänger bzw. an eine kombinierte Sende-Empfangs-Schaltung 5 angeschlossen. Die Koaxialleitung 4 ist gegenüber Erde unsymmetrisch. Um einen erdsymmetrischen Anschluß der Lokalspule zu erreichen, ist in einer Abstimmeinheit 3 eine Symmetrierschaltung vorgesehen. Diese besteht aus einem Differentialdrehkondensator mit zwei in Reihe geschalteten Kapazitäten 3a und 3b. Der Differentialdrehkondensator ist an die beiden Anschlüsse der Lokalspule 1 und 2 angeschlossen. Der Innenleiter der Koaxialleitung 4 ist über einen einstellbaren Anpaßkondensator 3c mit einem Anschluß der Lokalspule 1 und die Mantelabschirmung der Koaxialleitung mit dem Verbindungspunkt der beiden Kapazitäten 3a und 3b verbunden.

Bei dieser Anordnung ist ein Differentialdrehkondensator, also zwei Kondensatoren mit gemeinsamer Abgleichmöglichkeit, notwendig. Die Symmetrierschaltung ist nicht frequenzunabhängig. Die Abstimmeinheit muß in unmittelbarer Nähe der Lokalspule 1 angeordnet werden, was in der Praxis nachteilig ist.

Aus der eingangs genannten EP-A1-0 222 982 ist eine Lokalspule bekannt, die ohne Symmetrierschaltung an eine Koaxialleitung angeschlossen werden kann. Die Lokalspule ist als Schleife eines Koaxialleiters ausgeführt. Hierbei kann zur Erhöhung der Gesamt-Induktivität der Koaxialleiter auch mehrere Windungen aufweisen. In diesem Falle wird die Lokalspule aufgrund des verhältnismäßig großen Durchmessers der Koaxialleitung jedoch unhandlich und durch die große Leiteroberfläche steigt auch die kapazitive Verstimmung durch das Untersuchungsobjekt. Wenn die Windungen planparallel zueinander sein sollen, wird aufgrund des großen Durchmessers der Mantelabschirmung der Übergang zwischen den Windungen in der Herstellung aufwendig.

Aufgabe der Erfindung ist es daher, eine Lokalspule der eingangs genannten Art so auszuführen, daß ein einfacher kompakter Aufbau möglich ist und die kapazitive Verstimmung durch das Untersuchungsobjekt gering bleibt.

Diese Aufgabe wird erfindungsgemäß dadurch gelöst, daß die Verbindung über mindestens eine zweite Windung eines Innenleiters ohne Mantelabschirmung erfolgt, wobei der Windungssinn der zweiten Windung gleich dem Windungssinn der ersten Windung ist.

Der Innenleiter ohne Mantelabschirmung weist einen wesentlich geringeren Durchmesser als der vollständige Koaxialleiter auf. Dadurch wird das Bauvolumen verkleinert und die von der Oberfläche des Leiters abhängige kapazitive Verkopplung mit dem Untersuchungsobjekt reduziert.

Wenn die Lokalspule in einer vorteilhaften Ausführungsform über eine Koaxialleitung an eine Anpaßeinheit angeschlossen ist, kann die Anpaßeinheit vorteilhafterweise außerhalb des Untersuchungsbereiches angebracht sein. Dies erleichtert die Handhabung der Lokalspule.

In einer Ausführungsform der Erfindung können die erste und die weiteren Windungen unterschiedlichen Durchmesser haben. Damit können die weiteren Windungen in eine Ebene mit der ersten Windung gelegt werden, so daß die Bauhöhe der Lokalspule reduziert wird.

Die Erfindung wird nachfolgend anhand eines Ausführungsbeispiels nach den FIG 2 bis 4 näher erläutert. Dabei zeigen:

FIG 2 ein erstes Ausführungsbeispiel der Erfindung mit einer weiteren Windung,

FIG 3 ein zweites Ausführungsbeispiel der Erfindung mit zwei weiteren Windungen,

FIG 4 ein Ausführungsbeispiel der Erfindung mit einem Kondensator an der Lokalspule.

Beim Ausführungsbeispiel nach FIG 2 ist die Lokalspule 1 über eine Koaxialleitung 4 und eine Abstimmeinheit 3 an eine Sende-/Empfangseinheit 5 angeschlossen. Die Abstimmeinheit 3 enthält einen in Serie in den Innenleiter der Koaxialleitung 4 geschalteten Anpassungskondensator 3c und einen zwischen Innenleiter und Mantelabschirmung des Koaxialleiters 4 geschalteten Abstimmkondensator 3d zur Anpassung der Lokalspule 1 an die Betriebsfrequenz. Das Leiterstück 4b des Koaxialleiters zwischen Abstimmeinheit 3 und Lokalspule 1 wird zweckmäßigerweise so gewählt, daß die Abstimmeinheit 3 außerhalb des Untersuchungsbereiches angeordnet werden kann. Die Lokalspule 1 kann aber auch direkt, d.h. ohne Zwischenschaltung des Leitungsstückes 4b mit der Abstimmeinheit 3 verbunden sein.

Die Lokalspule enthält im dargestellten Ausführungsbeispiel eine Windung 1 als Fortsetzung der Koaxialleitung 4. Ein weiterer Leiter ohne Mantelabschirmung wird zu einer weiteren Windung 2 geformt, die zur ersten Windung konzentrisch ist. Das Ende dieses Innenleiters wird mit der Mantelabschirmung 1b an einem Punkt 6 am Beginn der ersten Windung verbunden. Beide Windungen 1, 2 haben dabei denselben Windungssinn.

Bei dieser Anordnung wirkt die erste Windung 1 des Innenleiters 1a mit der Mantelabschirmung 1b als Symmetrierglied. Aufgrund des kapazitiven Nebenschlusses zwischen dem Innenleiter 1a und der Mantelabschirmung 1b ergibt sich, daß vom Verbindungspunkt 6 aus betrachtet der Punkt 7 am Austritt des Innenleiters 1a aus der Mantelabschirmung 1b ein erdsymmetrisches mittleres Potential aufweist. Der Punkt 6 besitzt daher Erdpotential, ohne direkt geerdet zu sein.

Die unsymmetrische Koaxialleitung 4 als Verbindungsleitung zur Sende-/Empfangseinheit 5 stört die Stromverteilung in der Lokalspule bzw. die Symmetrie der Anordnung nicht, da der Außenleiter 1b keine Spannung gegen Erde hat. Dadurch entstehen keine Mantelströme in der Mantelabschirmung 1b, die über das Meßobjekt als Verluststrom in die Lokalspule eingekoppelt werden könnten. Solche Verlustströme würden zu einer Frequenzverstimmung der Lokalspule, zu einer Verschlechterung der Systemgüte und damit zu einem Rückgang der Empfindlichkeit führen.

Die Leiteroberfläche der zweiten Windung 2 ist bezüglich der Leiteroberfläche der ersten Windung 1b reduziert. Typischerweise weist die zweite Windung 2 den doppelten Durchmesser des Innenleiters 1a auf, um einerseits die Verluste gering zu halten, andererseits aber auch die Kapazität der Windung 2 nicht zu groß werden zu lassen. Da die Mantelabschirmung 1b üblicherweise den vierfachen Durchmesser des Innenleiters 1a hat, weist die Windung 2 nur den halben Durchmesser der Mantelabschirmung 1b auf. Damit bewirkt die zweite Windung 2 auch eine um den Faktor 2 geringere kapazitive Verstimmung durch das Untersuchungsobjekt. Zweckmäßigerweise wird man daher bei dieser Anordnung die zweite Windung 2 dem Meßobjekt zuwenden.

Der Abgleich auf die Resonanzfrequenz erfolgt durch den Kondensator 3d in der Abstimmeinheit 3 und die Anpassung an die Leitungsimpedanz durch den Kondensator 3c.

Der Durchmesser der beiden Windungen 1, 2 kann unterschiedlich sein. Ebenso kann auch der Abstand zwischen den Windungen variiert werden.

Das Spulensystem kann außer in Kreisform zur besseren Anpassung an ein Untersuchungsobjekt auch rechteckig, quadratisch, oval oder elliptisch ausgeführt werden. Ebenso ist eine Kombination der ersten Windung 1 und der weiteren Windungen in verschieden geometrischer Form möglich.

Bei der erfindungsgemäßen Anordnung kann eine Planparallelität der Windungen ohne besonderen Aufwand erreicht werden. Der Übergang zwischen erster Windung und weiteren, planparallelen Windungen, bereitet fertigungstechnisch keinerlei Schwierigkeiten.

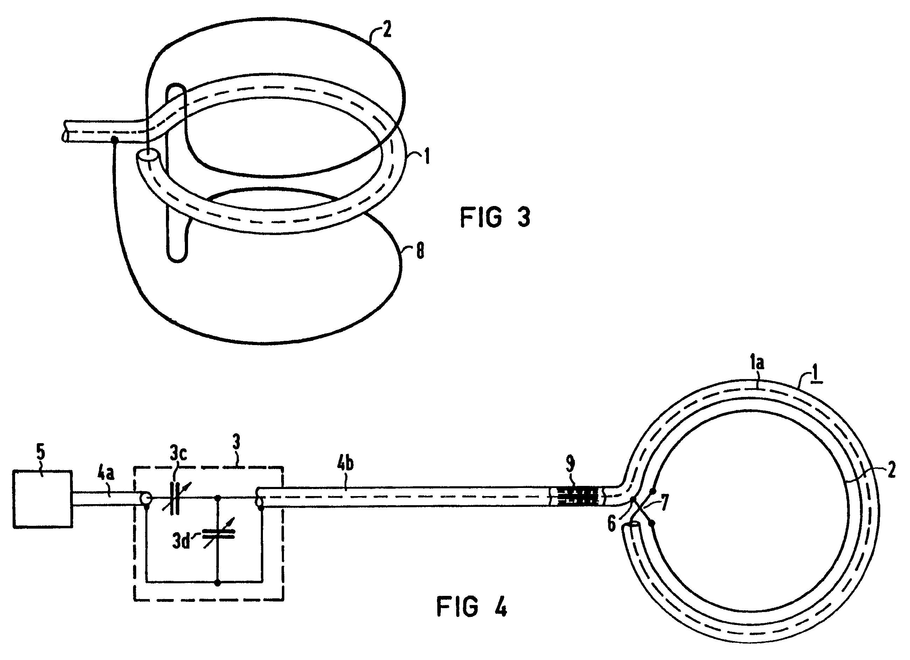

Ein weiteres Ausführungsbeispiel der Erfindung ist in FIG 3 dargestellt. Dabei sind zwei weitere Windungen 2 und 8 ohne Mantelabschirmung vorgesehen. Die weiteren Windungen 2 und 8 sind konzentrisch und planparallel zur ersten Windung 1 angeordnet, wobei die erste Windung 1 zwischen den beiden weiteren Windungen 2 und 8 liegt.

Es können auch mehr als zwei zusätzliche Windungen vorgesehen sein, so daß die Induktivität nochmals erhöht werden kann. Eine Grenze für die Windungszahl liegt lediglich darin, daß die Symmetrierwirkung der als Koaxialleitung ausgeführten Windung 1 mit zunehmender Anzahl von zusätzlichen Windungen nachläßt. Wenn man bei der Anordnung in FIG 3 eine Windung 2 oder 8 wegläßt, so erhält man eine Helmholtz-Anordnung.

Bei Verwendung einer Koaxialleitung zwischen der Lokalspule 1 und der Abstimmeinheit 3 werden die Verluste der Koaxialleitung in den Resonanzkreis (1) transformiert. Dies führt zu einer Reduzierung der Kreisgüte und damit zu einem Empfindlichkeitsverlust des Systems.

Dieser Nachteil läßt sich dadurch weitgehend beseitigen, indem der Anteil der Kreiskapazität, der nicht für die Anpaßvariation der Kapazität 3c und 3d für die jeweilige Impedanz des Übertragungssystems benötigt wird, als Festkapazität 9 unmittelbar an die Lokalspule 1 gebracht wird.

Die Festkapazität 9 wird gemäß dem Ausführungsbeispiel nach FIG 4 in koaxialer Bauweise ausgeführt. Die koaxiale Bauform dieser Festkapazität 9 erlaubt bei entsprechender Oberflächenbehandlung der Kondensatorbeläge, die wirksamen ohmschen Verluste auch verbunden mit Skineffekt-Verlusten bei höheren Frequenzen herabzusetzen. Gleichzeitig wird durch die Außenabschirmung der Kapazität Energieverlust durch Abstrahlung vermieden.

Eine weitere Möglichkeit zur Einbringung einer koaxialen Kapazität besteht in der begrenzten Reduzierung des Wellenwiderstandes der 1. Windung des Lokalspulensystems 1.

## Ansprüche

1. Lokalspule für die spektroskopische oder bildgebende Untersuchung eines Objektes mit Hilfe der kernmagnetischen Resonanz, wobei die Lokalspule ein zu einer ersten Windung geformtes Koaxialleiterstück (1) aufweist, wobei an einem Ende des Koaxialleiterstückes (1) der Innenleiter (1a) mit der Mantelabschirmung (1b) am Anfang (6) der ersten Windung (1) elektrisch verbunden ist, **dadurch gekennzeichnet,** daß die Verbindung über mindestens eine zweite Windung (2) eines Innenleiters ohne Mantelabschirmung erfolgt, wobei der Windungssinn der zweiten Windung (2) gleich dem Windungssinn der ersten Windung (1) ist.

2. Lokalspule nach Anspruch 1, **dadurch gekennzeichnet,** daß die Lokalspule über eine Koaxialleitung (4b) an eine Abstimmeinheit (3) angeschlossen ist.

3. Lokalspule nach Anspruch 2, **dadurch gekennzeichnet,** daß der Anteil der Kreiskapazität, der nicht für die Anpaßvariation in der Abstimmeinheit (3) für die jeweilige Impedanz des Übertragungssystems benötigt wird, als Festkapazität (9) unmittelbar an der Lokalspule (1) angebracht wird.

4. Lokalspule nach Anspruch 3, **dadurch gekennzeichnet,** daß die Festkapazität (9) als Koaxialkondensator realisiert ist.

5. Lokalspule nach einem der Ansprüche 1 bis 4, **dadurch gekennzeichnet,** daß die erste und die weiteren Windungen (2, 8) unterschiedlichen Durchmesser haben.

6. Lokalspule nach einem der Ansprüche 2 bis 4, **dadurch gekennzeichnet,** daß mindestens zwei weitere Windungen (2, 8) vorgesehen sind und daß die erste Windung (1) zwischen den weiteren Windungen (2, 8) angeordnet ist.

7. Lokalspule nach einem der Ansprüche 1 bis 6, **dadurch gekennzeichnet,** daß die Windungen (2, 8) eine Kreisform aufweisen.

## Claims

1. Local coil for the spectroscopic or imaging examination of a subject with the help of nuclear-magnetic resonance, the local coil having a coaxial conductor element (1) formed into a first turn, the internal conductor (1a) being electrically connected at one end of the coaxial conductor element (1) to the jacket shielding (1b) at the start (6) of the first turn (1), **characterised in that** the connection takes place by way of at least a second turn (2) of an internal conductor without a jacket shielding, the winding sense of the second turn (2) being the same as the winding sense of the first turn (1).

2. Local coil according to claim 1, **characterised in that** the local coil is connected by way of a coaxial line (4b) to a tuning unit (3).

3. Local coil according to claim 2, **characterised in that** the portion of the circuit capacitance which is not needed for the matching variation in the tuning unit (3) for the respective impedance of the transmission system, is attached as a fixed capacitance (9) directly to the local coil (1).

4. Local coil according to claim 3, **characterised in that** the fixed capacitance (9) is realized as a coaxial capacitor.

5. Local coil according to one of claims 1 to 4, **characterised in that** the first and the further turns (2, 8) have different diameters.

6. Local coil according to one of claims 2 to 4, **characterised in that** at least two further turns (2, 8) are provided, and in that the first turn (1) is arranged between the further turns (2, 8).

7. Local coil according to one of claims 1 to 6, **characterised in that** the turns (2, 8) have a circular shape.

## Revendications

1. Bobine locale pour l'examen spectroscopique ou avec formation d'images d'un objet à l'aide de la résonance magnétique nucléaire, la bobine locale possédant un élément conducteur coaxial (1) réalisé sous la forme d'une première spire, et dans laquelle, à une extrémité de l'élément de conducteur coaxial (1), le conducteur intérieur (1a) est raccordé électriquement au blindage-enveloppe (1b) au début (6) de la première spire (1), caractérisée par le fait que la liaison est réalisée au moyen d'au moins une seconde spire (2) d'un conducteur intérieur sans blindage-enveloppe, le sens de la seconde spire (2) étant identique à celui de la première spire (1).

2. Bobine locale suivant la revendication 1, caractérisée par le fait qu'elle est raccordée par l'intermédiaire d'un câble coaxial (4b) à une unité d'action (3).

3. Bobine locale suivant la revendication 2, caractérisée par le fait que la partie de la capacité variable, qui n'est pas nécessaire pour la variation d'adaptation dans l'unité d'accord (3) pour l'impédance respective du système de transmission, est montée directement sur la bobine locale (1) en tant que capacité fixe (9).

4. Bobine locale suivant la revendication 3, caractérisée par le fait que la capacité fixe (9) est réalisée sous la forme d'un condensateur coaxial.

5. Bobine locale suivant l'une des revendications 1 à 4, caractérisée par le fait que la première spire et les autres spires (2, 8) possèdent des diamètres différents.

6. Bobine locale suivant l'une des revendications 2 à 4, caractérisée par le fait qu'il est prévu au moins deux autres spires (8) et que la première spire (1) est disposée entre les autres spires (2, 8).

7. Bobine locale suivant l'une des revendications 1 a 6, caractérisée par le fait que les spires (2, 8) possèdent une forme circulaire.

FIG 1

FIG 2

FIG 3

FIG 4